**Europäisches Patentamt**

(19) **European Patent Office**

**Office européen des brevets**

(11) Publication number: **0 146 962**

**A2**

# (12) EUROPEAN PATENT APPLICATION

(21) Application number: **84116286.0**

(22) Date of filing: **24.12.84**

(51) Int. Cl.⁴: **H 01 L 29/80**
**H 01 L 29/36**

(30) Priority: **26.12.83 JP 243830/83**

(43) Date of publication of application:
**03.07.85 Bulletin 85/27**

(84) Designated Contracting States:
**DE FR GB NL**

(71) Applicant: **HITACHI, LTD.**
**6, Kanda Surugadai 4-chome Chiyoda-ku**
**Tokyo 100(JP)**

(72) Inventor: **Katayama, Yoshifumi**
**1303-9, Shimotomi Tokorozawa-shi**
**Saitama-ken(JP)**

(72) Inventor: **Shiraki, Yasuhiro**
**1-106, 3-26-1, Hirayama**
**Hino-shi Tokyo(JP)**

(72) Inventor: **Murayama, Yoshimasa**
**4-2-1-320, Maehara-cho**
**Koganei-shi Tokyo(JP)**

(72) Inventor: **Maruyama, Eiichi**
**1572-3, Josuihoncho**
**Kodaira-shi Tokyo(JP)**

(72) Inventor: **Morioka, Makoto**
**2196-64, Hirai Hinodemachi**
**Nishitama-gun Tokyo(JP)**

(74) Representative: **Strehl, Schübel-Hopf, Schulz**
**Widenmayerstrasse 17 Postfach 22 03 45**
**D-8000 München 22(DE)**

(54) **Semiconductor device having hetero-structure.**

(57) Disclosed herein is a semiconductor device having a first semiconductor layer and a second semiconductor layer that are arranged to form a hetero-junction, a band gap of said first semiconductor layer being smaller than that of said second semiconductor layer, and having a source and a drain that are electronically connected to said first semiconductor layer, and further having a gate electrode, wherein there exists at least a region containing impurities at a concentration of smaller than $10^{16}$ cm$^{-3}$ between said source and said drain, and said drain region is not separated away from an end of the gate by more than the thickness a depletion layer. This enables the breakdown voltage to be increased between the drain and the gate, and the tolerance to be increased in the manufacturing steps.

FIG. 3

Title of the Invention

SEMICONDUCTOR DEVICE HAVING HETERO-STRUCTURE

Background of the Invention

Field of the Invention

The present invention relates to a semiconductor device having hetero-structure.

Description of the Prior Art

Gallium arsenide (GaAs) exhibits an extremely high electron mobility compared with that of silicon, and serves as a material that is suited for producing high-speed devices. However, since it is difficult to form an insulating layer of good quality on this material, an MOS (metal oxide semiconductor) type field-effect transistor using this material instead of silicon has not been realized yet. In recent years, however, it has been found that if an aluminum gallium arsenide (AlGaAs) crystal to which donor impurities are added is used in place of the insulating layer, carriers are induced on the interface thereof, making it possible to prepare a field-effect transistor.

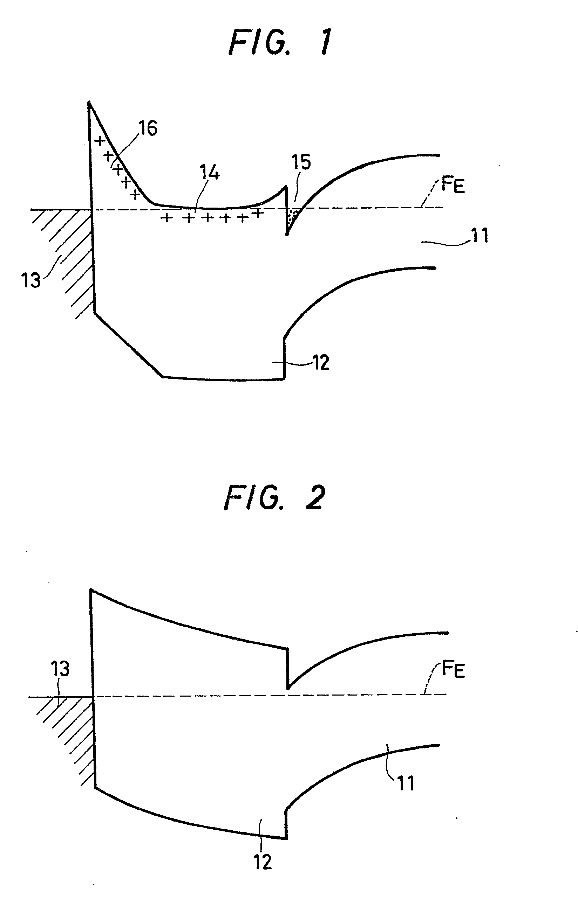

Fig. 1 is a diagram showing a band structure of the operating region of the transistor, wherein reference numeral 13 denotes an electrode portion, 12 denotes an aluminum gallium arsenide layer containing impurities, and 11 denotes a gallium arsenide layer without substantially containing impurities. Symbol $F_E$ denotes a Fermi-level.

In Fig. 1, reference numeral 15 denotes carriers that are confined in a two-dimensional potential. The carriers 15 are supplied from a donor impurity level 14 in the AlGaAs layer 12 and run through the GaAs layer 11 that does not contain impurities. That is, the carriers 15 are isolated in place from the ionized donor impurities. Therefore, scattering caused by an impurity potential is reduced conspicuously, and a high electron mobility is obtained. When a transistor is prepared using electrons of high mobility, however, large amounts of donors added into the AlGaAs layer prevent a gate voltage from being effectively applied to the interface region, and the transconductance decreases. To avoid this inconvenience, it is desired to use the AlGaAs layer without containing impurities like the MOS structure.

In the case of the Schottky-type gate, however, gaps are formed among the source and drain electrodes and the channel unlike the case of the MOS structure. When donor impurities are not added to the AlGaAs layer or the GaAs layer, therefore, no carrier is induced in the gaps. In other words, the channel is not connected to the source and drain electrodes, and the transistor does not work.

To eliminate the above-mentioned defect, the following semiconductor device has been proposed as disclosed, for example, in Japanese Patent Laid-Open No. 91682/1983. The gist of this semiconductor device resides in a field effect transistor in which donor impurities are introduced into the semiconductor of the side of gate electrode having a wide band gap in the gap region between the channel and the source/ drain electrode. That is, donor impurities are introduced into the AlGaAs layer in the above-mentioned case, and impurities are not introduced into the channel portion just under the gate electrode.

With the above-mentioned structure, (1) the mobility increases since there exist no impurities that serve as scattering centers in the AlGaAs layer in the vicinity of the channel, (2) the AlGaAs layer works similarly to the insulating layer in the MOS transistor, and hence the gate voltage can be effectively applied to the channel to increase the transconductance, and (3) carriers are supplied from donor impurities to the gaps, enabling the channel to be connected to the source/ drain electrode, and enabling the device to work as a transistor.

In the case of a field-effect transistor having hetero-structure consisting of AlGaAs and GaAs, furthermore, a difference of about 0.3 eV exists on the
interface of conduction band between the GaAs and the
AlGaAs, and a Schottky barrier of about 0.6 eV exists.
Therefore, when the AlGaAs without containing impurities
is used, the channel is not formed under the condition where a gate voltage is not applied. Fig. 2 shows
the band structure of this case, wherein reference
numeral 13 denotes an electrode portion, 12 denotes an
AlGaAs layer, 11 denotes a GaAs layer, and $F_E$ denotes
a Fermi-level. Fig. 2 shows the normally-off condition
where the channel is formed when a positive voltage is
applied to the gate. That is, the transistor in this
case is of the enhancement type.

Summary of the Invention

In dealing with a field-effect transistor FET
based upon the hetero-structure without containing
impurities as mentioned above, the object of the present invention is to provide a semiconductor device
in which positions and structure of regions into which
impurities are introduced to form source and drain
regions are so contrived as to increase the breakdown
voltage between the drain and the gate, to increase
the tolerance in the manufacturing steps and to
increase the yields.

The semiconductor device according to the present invention has a fundamental structure as described below.

That is, the semiconductor device has at least a first semiconductor layer and a second semiconductor layer for forming a hetero-junction that constitutes a carrier transit region, means for controlling carriers, and means for sending and receiving carriers, wherein a region that contains impurities at a concentration smaller than $10^{16}$ $cm^{-3}$ exists in the semiconductor layer between means for sending carriers and means for receiving carriers.

In the thus constructed semiconductor device according to the present invention, the drain region is not separated away from the end of the gate by more than twice the thickness of the depletion layer.

Impurities are usually contained at a concentration of higher than $10^{17}$ $cm^{-3}$ in the regions adjacent to the source and drain. The upper limit of impurity concentration is usually $3 \times 10^{18}$ $cm^{-3}$.

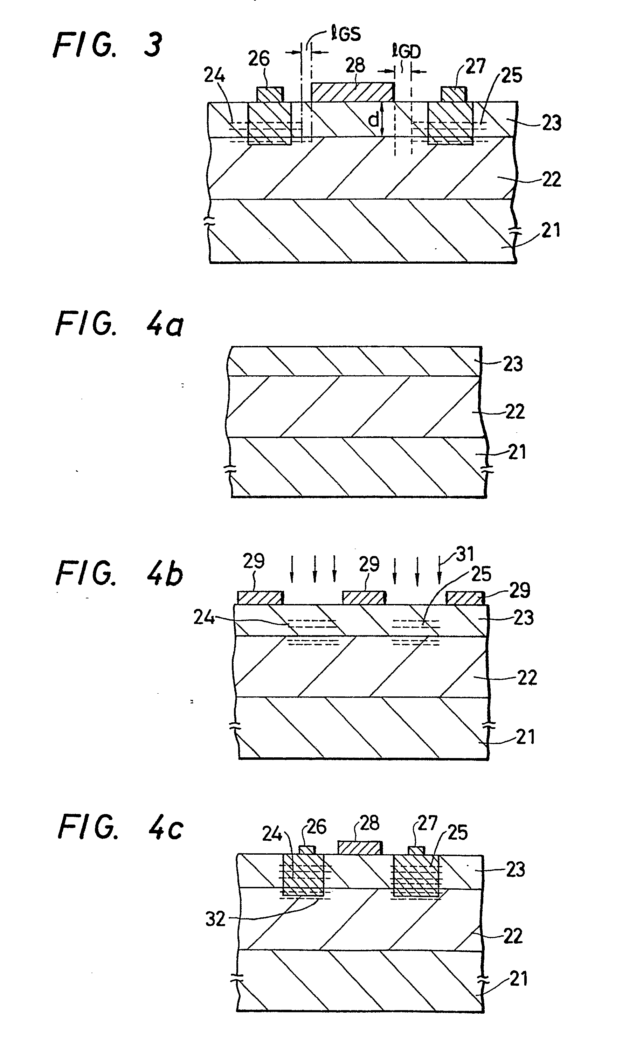

The important point of the present invention will be described with reference to a field-effect transistor FET of the structure shown in Fig. 3. Usually, regions 24 and 25 into which impurities are introduced and which serve as source and drain regions are overlapped under a gate electrode 28, or are terminated just under the ends of the gate electrode (other portions of Fig. 3 are denoted by the same reference numerals as those of Fig. 4, and the description related to Fig. 4 should be referred to). With the above structure, however, the drain breakdown voltage decreases when the gate length becomes very small.

According to the present invention which utilizes the feature of the hetero-structure, the above defect is precluded by forming a gap between the end of the gate electrode and the drain region. If the gap length $\ell_{GD}$ is too great, the device does not work as a field-effect transistor. It is allowable to increase the gap length $\ell_{GD}$ to be nearly equal to the thickness of the depletion layer (i.e., the thickness which can substantially be regarded to be that of the depletion layer). The gate breakdown voltage decreases if the source region 24 and the gate electrode overlap upon each other over a wide area. This, however, can be solved by bringing the regions into which impurities are introduced away from the surface such that the impurity concentration in the surface is smaller than about $10^{17}$ cm$^{-3}$. The above contrivance makes it possible to increase the drain breakdown voltage and to increase the yields for producing the elements since the precision for aligning the gate electrode and the source and drain regions can be greatly loosened.

The effect for increasing the drain breakdown voltage based upon the gap $\ell_{GD}$ between the gate electrode 28 and the drain region 25, is observed when the gap $\ell_{GD}$ reaches a thickness d of the semiconductor layer 23 that is not doped with impurities. If the gap $\ell_{GD}$ becomes too great, however, a series resistance increases between the source and the drain, and the field-effect transistor exhibits deteriorated characteristics. The limit of the thus determined gap $\ell_{GD}$ is twice the thickness W of the depletion layer under the condition where the gate voltage is zero.

That is,

$$d \leqq \ell_{GD} \leqq 2W$$

where

$$W = \sqrt{\frac{2Es(\triangle Vc + VG)}{eN_B}}$$

wherein

Es: dielectric constant in the layer 22,

$N_B$: impurity concentration in the layer 22,

e: electric charge of an electron,

$\triangle Vc$: voltage difference at the ends of conduction bands on the interface between the layer 23 and the layer 22,

VG: gate voltage.

In the embodiment that will be mentioned later, the voltage difference $\Delta V_c$ is about 0.3 eV. Therefore, if $NB = 10^{15}$ cm$^{-3}$, the width W of the depletion layer is about 5000 angstroms at VG = 0 (V).

If the gap $\ell_{GS}$ is increased between the gate electrode and the source region, on the other hand, the efficiency for injecting carriers from the source region decreases. Therefore, it is not allowed to increase the gap $\ell_{GS}$ to be greater than the thickness d of the semiconductor layer 23.

The above description has concretely explained a semiconductor device of the type of GaAs-GaAℓAs layers. The invention, however, can be adapted to other compound semiconductor materials that constitute the hetero-junction, as a matter of course.

Examples include $A\ell_y Ga_{1-y} As - A\ell_x Ga_{1-x} As$, GaAs-AℓGaAsP, InP-InGaAsP, InP-InGaAs, InAs-GaAsSb, and the like.

Brief Description of the Drawings:

Fig. 1 is an energy diagram of a conventional hetero-junction type field-effect transistor;

Fig. 2 is an energy diagram of a transistor according to the present invention;

Fig. 3 is a section view showing the structure of the transistor according to the present invention;

Figs. 4a to 4c are section views showing steps for producing the field-effect transistor; and

Figs. 5a to 5d are section views showing the transistor according to the present invention.

Detailed Description of the Preferred Embodiments Embodiment 1

Figs. 4a to 4c illustrate principal steps.

On a semi-insulating GaAs substrate 21 is grown a GaAs layer 22 to which impurities are not intentionally added to a thickness of about 1 $\mu$m (usually about 5000 angstroms to 1.5 $\mu$m) maintaining a substrate temperature of 580°C by the molecular beam epitaxy method. Then, an AℓGaAs layer 23 having an Aℓ to Ga composition ratio of about 0.3 to 0.7 is grown thereon to a thickness of 1200 angstroms (selected roughly over a range of 500 to 5000 angstroms) (Fig. 4a). Though impurities are not particularly added to any of the layers, the donor concentration in the GaAs layer 22 is about $1 \times 10^{15}$ $cm^{-3}$.

Silicon oxide $SiO_2$ is grown to a thickness of about 4000 angstroms on the above epitaxial layer by the CVD method (chemical vapor deposition method), and silicon ions 31 are implanted at 70 KeV and at a concentration of $2 \times 10^{13}$ $cm^{-3}$ using as a mask the $SiO_2$

layer 29 from which portions that will serve as source and drain regions have been removed by etching relying upon the photolithographic technique. Lattice detects caused by the implantation of ions are removed, and the flash annealing is effected at 850°C for five seconds in order to activate the ions. The impurity regions are denoted by 24 and 25 in Fig. 4b. It is desired to effect the annealing for a longer period of time in order to enhance the activation efficiency of ions. The annealing, however, is effected under the above-mentioned conditions in order to prevent blurring from occurring on the interface of A$\ell$GaAs and GaAs and to prevent impurities from diffusing.

As the donor impurities, use can be made of germanium ions, tin ions, tellurium ions, selenium ions, sulfur ions or like ions in addition to silicon ions. The concentration of impurities that are implanted at about $10^{13}$ to $10^{14}$ cm$^{-3}$ is determined by a degree for producing the carriers.

The source and drain electrode regions are formed by the conventional alloy method being juxtaposed to the ion-implanted layer. To form the source and drain regions, for example, an Au-Ge alloy (2000 $\overset{o}{A}$)-Ni (150 $\overset{o}{A}$)-Au (3000 $\overset{o}{A}$) is deposited on predetermined portions 26, 27, and is heated at 400°C for five minutes in a hydrogen atmosphere.

Then, the metal aluminum is deposited on a predetermined portion to form a gate electrode, thereby to obtain a field-effect transistor FET having gate which is 2 μm long.

The distance between the ends of gate and the source and drain regions can be sufficiently controlled by the currently employed masking technique.

The thus obtained transistor exhibited a mobility of about 1.2 times, a transconductance which is about two times, a drain breakdown voltage of 1.5 times, and a gate breakdown voltage of two times as great as those of the conventional selectively doped hetero-structured field-effect transistor that is obtained by adding donors at a concentration of about $2 \times 10^{18}$ $cm^{-3}$ into the AℓGaAs layer.

As for a relation between the position of drain region and the position of gate electrode, good operation characteristics are obtained when the gap lies over a range of 1200 angstroms to 1 μm. The semiconductor laser of the present invention enables the tolerance in the manufacturing steps to be greatly increased, and the breakdown voltage between the gate and the drain to be increased while minimizing the increment of series resistance across the source and the drain.

Table 1 shows series resistance between the source and the drain, and breakdown voltage between the gate and the drain when the gap $\ell_{GD}$ is set to various values in the above-mentioned concrete embodiment.

Table 1

| $\ell_{GD}$ | 0 | W** | 2W | 3W |
|---|---|---|---|---|
| Gate-drain breakdown voltage | 1.0 | 1.3 | 1.5 | 2.0 |
| Series* resistance | 1.0 | 1.1 | 1.2 | 2.0 |
| Remarks | | Scope of the invention | | |

*: indicated in terms of relative values

**W: width of the depletion layer at VG = 0 (V).

Good operation characteristics are also obtained even when the GaAs layer without implanted with impurities is formed to protect the surface of the AℓGaAs layer instead of forming the AℓGaAs layer 23 into which impurities have not been implanted.

Good operation characteristics are further obtained even when the layer 22 without implanted with impurities is used in combination with the AℓGaAs or GaAs layer 30 that is implanted with p-type or n-type impurities, instead of using the GaAs layer 22 without implanted with impurities.

Good operation characteristics are obtained even when the GaAs substrate implanted with n-type impurities is used instead of the semi-insulating GaAs substrate.

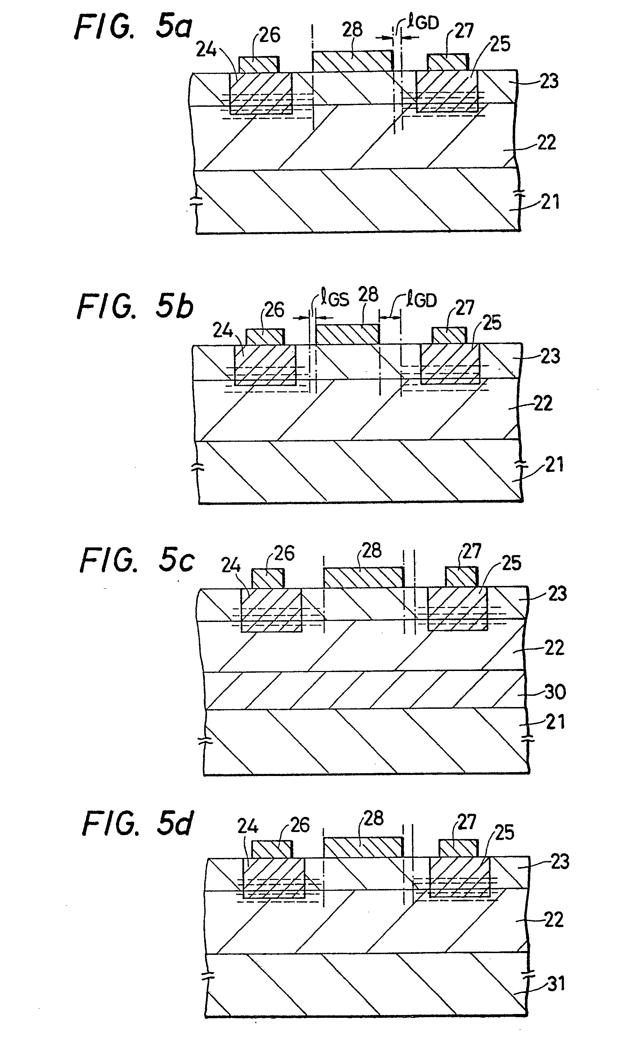

Figs. 5a to 5d illustrate representative examples of the structure that exhibit good operation characteristics.

In Figs. 5a to 5d, the same reference numerals as those of Fig. 3 or Figs. 4a to 4c denote the same portions that are arranged as viewed in cross section.

Fig. 5a shows the structure in which the source region is in alignment with the end of the gate electrode, and the drain region is separated away from the end of the gate electrode by a gap $\ell_{GD}$.

Fig. 5b shows the structure in which both the source region and the drain region are separated away from the ends of the gate electrode.

Fig. 5c shows the structure in which an AℓGaAs alyer or a GaAs layer 30 implanted with p-type or n-type impurities is formed on the substrate 21.

Fig. 5d shows the structure in which use is made of a GaAs substrate implanted with n-type impurities instead of the semi-insulating GaAs substrate.

What is claimed is:

1.     In a semiconductor device having a first semiconductor layer and a second semiconductor layer that
are arranged to form a hetero-junction, a band gap of
said first semiconductor layer being smaller than
that of said second semiconductor layer, and having a
source and a drain that are electronically connected to
said first semiconductor layer, and further having a
gate electrode, the improvement wherein there exists
at least a region containing impurities at a concen-
tration of smaller than $10^{16}$ cm$^{-3}$ between said source
and said drain, and said drain region is not separated
away from an end of the gate by more than twice the
thickness of a depletion layer under the condition
where the gate voltage is zero volt.

2.     A semiconductor device according to claim 1,
wherein a gap between the end of the gate and the drain
region is larger than the thickness of the first
semiconductor layer but is not larger than twice the
thickness of the depletion layer under the condition
where the gate voltage is zero volt.

3.     A semiconductor device according to claim 1,
wherein the gap between the end of said gate and said
source region is not larger than the thickness of said
first semiconductor layer.

4.	A semiconductor device according to claim 2, wherein the gap between the end of said gate and said source region is not greater than the thickness of said first semiconductor layer.

## FIG. 1

## FIG. 2

FIG. 3

FIG. 4a

FIG. 4b

FIG. 4c

FIG. 5a

FIG. 5b

FIG. 5c

FIG. 5d